(19)

Europäisches Patentamt
European Patent Office
Office européen des brevets

(11) **EP 3 285 383 A1**

(12) **EUROPEAN PATENT APPLICATION**

(43) Date of publication:
**21.02.2018 Bulletin 2018/08**

(51) Int Cl.:
**H02M 1/44** (2007.01) **H01F 17/00** (2006.01)

(21) Application number: **16184177.0**

(22) Date of filing: **15.08.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB Technology Oy**
**00380 Helsinki (FI)**

(72) Inventors:
• **Masti, Mika**
**00380 Helsinki (FI)**
• **Kinnunen, Henri**
**00380 Helsinki (FI)**
• **Laitinen, Matti**
**00380 Helsinki (FI)**

(74) Representative: **Kolster Oy Ab**
**(Salmisaarenaukio 1)**
**P.O. Box 204**
**00181 Helsinki (FI)**

(54) **CURRENT CONDUCTOR STRUCTURE WITH FREQUENCY-DEPENDENT RESISTANCE**

(57) The present disclosure describes a current conductor structure with a frequency-dependent resistance. The current conductor structure comprises a first current conductor and a second current conductor connected in parallel. The first and second current conductor are configured such that the second current conductor has a higher resistance and a lower inductance than the first conductor so that, above a set frequency limit, the resistance component of a total impedance of the current conductor structure is larger than the resistance component of the impedance of the first conductor current.

Figure 1

EP 3 285 383 A1

## Description

FIELD

The present disclosure relates to high-frequency electrical emissions and particularly to damping of such emissions in a power converter.

BACKGROUND

Rated powers of power electronics converters may range from several hundreds of watts to megawatts, for example. This power may be transmitted at frequencies that are in the range of few Hertz to hundreds of Hertz. Power electronics converters may use hard-switched semiconductors for switching of currents and voltages. Because of this, the semiconductors may be a source of a wide bandwidth of voltages and currents at frequencies other that those used for transmitting the power. The electromagnetic energy in these high-frequency currents and voltages may be small in comparison to the rated power of the converter, but the currents and voltages may still be harmful to the electrical environment or to the converter itself. In a frequency converter, for example, oscillating high-frequency currents may cause additional losses in components of the converter, and high-frequency voltages may induce additional stress to the components and age them prematurely, especially in commutation circuits of switching components of the frequency converter.

In EMC standards covering frequency converters, emissions may be categorized into conductive and radiated emissions. The EMC standards may place limits for conductive emissions in a set frequency range, e.g. from 150 kHz to 30 MHz. Similarly, limits may be placed for radiated emission frequencies in a set range, e.g. from 30 MHz to 1 GHz. Harmful high-frequency content produced by a frequency converter may be in the form of conducted and radiated emissions.

In general, there are two basic approaches for mitigating high-frequency emissions: decreasing the amplitude of high-frequency components at the source and preventing high-frequency emissions from entering the environment by conducting them to components or structures in which they are dissipated into power losses.

The methods for mitigating effects of fast switching in a converter are similar. The rate of change of the voltages and currents may be decreased by slowing down the switching components. Alternatively, or in addition, oscillating high-frequency currents may be dampened with resistance components.

The switching components of a frequency converter may have the highest impact on power losses of the converter. Thus, slowing them down may induce high additional power losses thereby having a significant negative effect on a total efficiency of the converter. Further, even with a dedicated gate control of active switches such as IGBTs, frequency content of the additional losses may not be selectively controllable. For example, the turn-on speed of a modern IGBT may be controlled fairly well at a given operating point defined by a given voltage, current and temperature, but the switching speed may be different at a different operating point. Furthermore, the rate of change of the voltage at a turn-off may be directly set by the design and operating point of the IGBT device, and thus, may not be controllable.

Both parallel and serial filtering may be used for damping the oscillating currents. The filtering is typically implemented as filtering circuits made of passive components, such as inductors, capacitors and resistors. These components may increase the cost and size of the converter. Further, in the case of a serial filtering, for example, both an inductance and a resistance may have negative effects to the efficiency of the power flow at fundamental frequency because of voltage drops and losses in conductors and cores of magnetic components. Placing resistors to the commutation circuits may also increase the inductance of the circuits which, in turn, may induce higher overvoltage spikes that may stress components inside, as well as outside the converter.

BRIEF DESCRIPTION

An object of the present disclosure is to provide a current conductor structure so as to alleviate the above disadvantages. The objects of the invention are achieved by a current conductor structure and a method for manufacturing the same, which are characterized by what is stated in the independent claims. The preferred embodiments of the invention are disclosed in the dependent claims.

In order to dampen undesired high-frequency emissions, a current conductor structure with two or more parallel current paths may be used. Each current route may have differing loop inductance and resistance values specifically selected to cause a higher resistance level at high frequencies.

The parallel current paths of a current conductor structure according to the present disclosure may be implemented as loop structures. The current conductor structure may be in the form of a laminate structure made of layers of insulating materials. The current paths may be in the form of thin strips of electrically conducting material running between and on top of the layers. The thin strips may be implemented as strips of metal foil, for example. Different materials may be used for each conductor. This enables formulation of current conductor structures with a wide range of desired resistances and limit frequencies. A current conductor structure according to the present disclosure can be integrated to the main current or commutation loops with a minimal negative effect to the power losses at the lower frequencies used for transferring power. Current conductor structures according to the present disclosure may also be used for selective parallel filtering.

With a current conductor structure according to the present disclosure, frequency-dependent losses may be added to a current path in order to dampen oscillations in the frequency ranges of conductive and radiated emissions (as well as in a frequency range of bearing currents, for example) without increasing the number of passive components in the current path. Frequency-dependant resistance may be added to the main circuit and commutation path without increasing inductance. A current conductor structure according to the present disclosure may be integrated to various places of the main circuit, e.g. the DC-bus, the commutation circuit, input and output bus. Thus, the structure may be used to distribute additional HF-damping throughout the main circuit. The current conductor structure may also be used as a part of parallel filtering instead using of separate passive components.

## BRIEF DESCRIPTION OF THE DRAWINGS

In the following the invention will be described in greater detail by means of preferred embodiments with reference to the accompanying drawings, in which

Figures 1 shows an exemplary schematic of a current conductor structure according to the present disclosure;
Figures 2a and 2b show exemplary, simplified diagrams of impedances of parallel current paths as functions of frequency;
Figures 3a to 3c show simplified examples of embodiments of the current conductor structure according to the present disclosure; and
Figures 4a and 4b show exemplary, simplified diagrams of impedances of parallel current paths implemented as thin conductor foils in a laminate structure.

## DETAILED DESCRIPTION

The present disclosure describes a current conductor structure with a frequency-dependent resistance. The current conductor structure may be in the form of a bus bar in a main circuit of a power electronics converter, for example. The power electronic converter, may be a frequency converter, for example.

The current conductor structure comprises at least a first current path and a second current path connected in parallel. The first and second current path are configured such that the second current path has a higher resistance and a lower inductance than the first current path. As a result, the resistance component of a total impedance of the current conductor structure is larger than the resistance component of the impedance of the first current path at frequencies above a set frequency limit. A current through a resistance dissipates power into heat. Therefore, the current conductor structure selectively dampens currents at frequencies above the set frequency limit through dissipation. The current conductor structure may be used in various places in power electronics devices. For example, the current conductor structure may be integrated to a main current or commutation loops of a power converter with minimal effect in the losses at those frequencies transferring the power. The current conductor structure may also be used for selective parallel filtering. The adjustable high-frequency damping provided by the current conductor structure may be integrated to a main circuit of a converter without a significant effect to losses at lower frequencies.

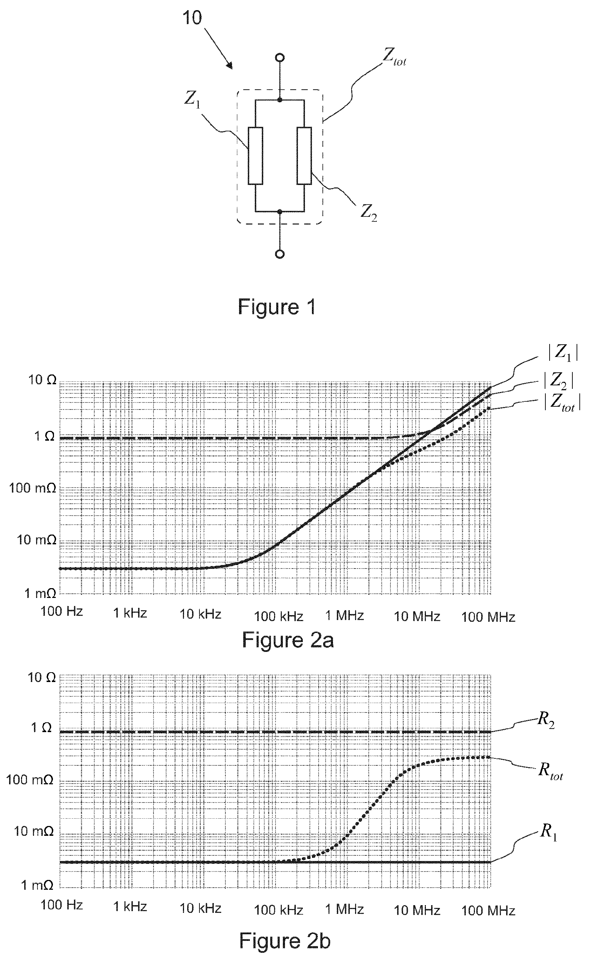

Figure 1 shows an exemplary schematic of a current conductor structure according to the present disclosure. In Figure 1, a current conductor structure 10 comprises a first current path and a second current path connected in parallel. The first current path is represented by a first impedance $Z_1$, and the second current path is represented by a second impedance $Z_2$. Together the first impedance $Z_1$ and the second impedance $Z_2$ form a total impedance $Z_{tot}$ of the current conductor structure 10.

The impedances $Z_1$ and $Z_2$ each consist of two components: a resistance component $R$ (i.e. resistance) and a reactive component $X$ (i.e. reactance). These components have a 90 degree phase shift between each other. The reactance in the current conductor structure according to the present disclosure is inductive, so the reactance leads the resistance. Such impedance may be defined as a complex number as follows, for example:

$$Z = R + jX = R + j\omega L, \qquad\qquad (1)$$

where $\omega L$ represents the amplitude of the reactive component. L represents the inductance of the current path and represents ω angular frequency.

The reactive component changes in response to frequency, whereas the resistance component ideally remains unchanged. At low frequencies where reactances of the current paths are low, a first impedance $Z_1$ of the first current path is lower than a second impedance $Z_2$ of the second current path because the second current path has a higher resistance. However, as the frequency ω increases, a reactance $X_1$ of the first current path rises faster than a reactance $X_2$ of the second current path because the first current path has a higher inductance. Thus, at a set limit frequency, the amplitude $|Z_1|$ of the first impedance $Z_1$ reaches (and then surpasses) the amplitude $|Z_2|$ of the second impedance $Z_2$.

Based on the impedances $Z_1$ and $Z_2$ of the first and second current path, the total impedance $Z_{tot}$ may be calculated as follows, for example:

$$Z_{tot} = \frac{Z_1 Z_2}{Z_1 + Z_2}. \tag{2}$$

The quality factor (i.e. the reactance-to-resistance ratio) of the total impedance $Z_{tot}$ calculated with Equation (2) is between the quality factors of the impedances of the first and second current path. The first and second current path may be configured such that, at low frequencies, the first impedance $Z_1$ is much lower than the second impedance $Z_2$. As a result, the divisor in Equation (2) is determined by the second impedance $Z_2$, and the result of the division is closer to the first impedance. However, at higher frequencies above the set limit frequency, the first impedance $Z_1$ is higher than the second impedance $Z_2$, and the result of Equation (2) is closer to the second impedance $Z_2$.

Figures 2a and 2b show exemplary, simplified diagrams of impedances of parallel current paths as functions of frequency. In Figure 2a, amplitudes $|Z_1|$, $|Z_2|$, and $|Z_{tot}|$ of impedances $Z_1$, $Z_2$ and $Z_{tot}$ are shown in a logarithmic scale. The first impedance $Z_1$ of the first current path is represented by a solid line, the second impedance $Z_2$ of the second current path is represented by a dashed line, and the total impedance $Z_{tot}$ of the parallel connection of the two current connectors is represented by a dotted line. In Figure 2b, respective resistance components $R_1$, $R_2$ and $R_{tot}$ of the impedances $Z_1$, $Z_2$ and $Z_{tot}$ are shown as function of frequency with corresponding line patterns. In Figure 2a and 2b, the first current path has a smaller resistance but a higher inductance than the second current path. The first path has a first resistance $R_1$ of 3 mΩ and a first inductance $L_1$ of 12.4 nH, whereas the second path has a second resistance $R_2$ of 0.85 Ω and a second inductance $L_2$ of 9.14 nH.

At lower frequencies in Figures 2a and 2b, the amplitude of the first impedance $Z_1$ is lower than the amplitude of the second impedance $Z_2$ and, thus, the first impedance determines the characteristics of the total impedance $Z_{tot}$. The resistance component $R_{tot}$ of the total impedance $Z_{tot}$ remains close to the resistance component $R_1$ of the first impedance $Z_1$. However, as the frequency increases in Figures 2a and 2b, the first impedance reaches the second impedance $Z_2$ at a limit frequency between 10 MHz and 20 MHz, and then exceeds the second impedance $Z_2$. As a result, the amplitude of the first impedance $Z_1$ is lower than the amplitude of the second impedance $Z_2$. Thus, the second impedance $Z_2$ now determines the characteristics of the total impedance $Z_{tot}$, and the resistance component $R_{tot}$ of the total impedance $Z_{tot}$ rises to close to the resistance component $R_2$ of the second impedance $Z_2$.

The frequency at which the second current path becomes dominant (i.e. the second current path has an impedance with a lower amplitude than the first current path) can be controlled through the selection of resistances and inductances of the first and second current path. It is thus possible to set a limit frequency at which dissipative power losses (caused by the resistance component of the total impedance) increase. The limit may represent a frequency above which undesirable emissions and oscillations are to be damped, for example.

A current conductor structure according to the present disclosure may be implemented such that the first and second current path are implemented as electrically conducting strips on a supporting laminate structure.

For example, a current conductor structure according to the present disclosure may comprise one or more layers of insulating material forming a supporting laminate structure, and a first electrically conducting strip acting as the first current path. The first electrically conducting strip may be arranged to form a first inductive loop that extends in a first direction parallel to the plane of the laminate structure and in a second direction perpendicular to the plane of the laminate structure. The current conductor structure may further comprise a second electrically conducting strip which acts as the second current path, wherein the second electrically conducting strip is arranged to form a second inductive loop that extends in the first and second direction. The dimensions of the first and second inductive loop in the first and second direction define loop areas of the first and second inductive loop. The dimensions may be selected such that the loop area of the first inductive loop is larger than the loop area of the second inductive loop.

With a laminate structure, the current conductor structure may be easily integrated to a DC busbar of a power converter in order to achieve extra high frequency resistance in commutation loop noise reduction, for example. An additional benefit of a current conductor structure according to the present disclosure is a lowered inductance on higher frequencies, which lowers peak voltage levels in the main circuit commutation loops of the power converter.

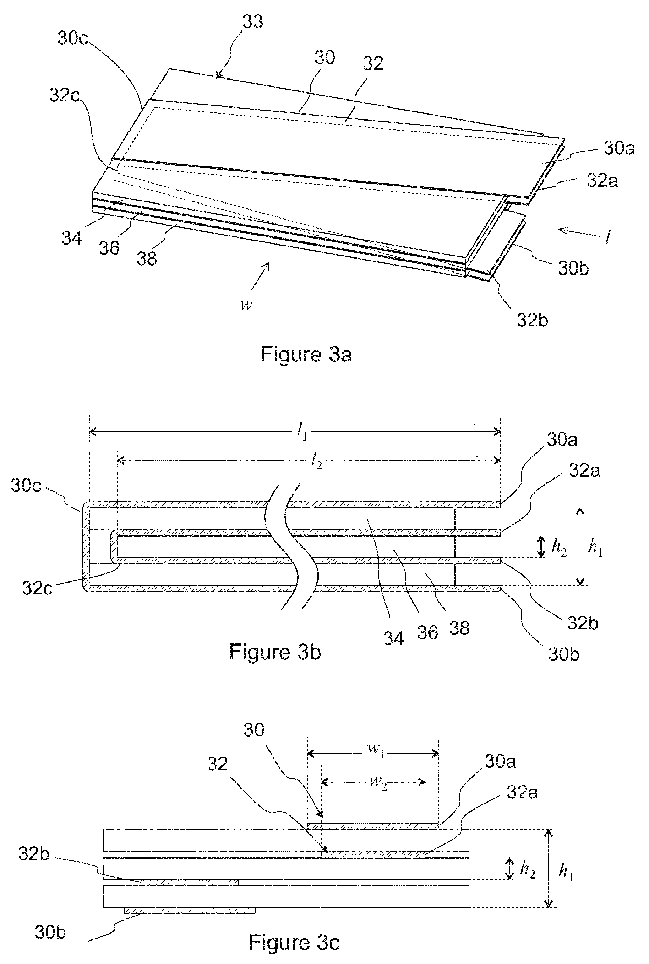

Figures 3a to 3b show simplified examples of embodiments of the current conductor structure according to the present disclosure. In Figure 3a, a perspective view of the current conductor structure is shown. The current conductor structure comprises a first electrically conducting strip 30 (which acts as the first current path) and a second electrically conducting strip 32 (which acts as the second current path) on a supporting laminate structure 33 comprising a plurality of layers. Figure 3a also shows two perpendicular axes w and *l*. The widths of the laminate structure 33 and its layers may be defined along axis w while the lengths of the laminate structure 33 and its layers may be defined along axis *l*. Together, the axes w and *l* define the plane of the laminate structure 33. Figure 3b shows a simplified cross section perpendicular to the width axis w. Figure 3c shows a simplified cross section perpendicular to the length axis *l*.

The laminate structure 33 in Figures 3a to 3c comprises three layers 34, 36, and 38. Each of the layers 34, 36, and 38 may be made of an insulating material. The layers may be made of the same material, or different materials. The layers may have the same thickness or different thicknesses.

The first conducting strip 30 and the second conducting strip 32 both have their first ends 30a and 32a, respectively, on a first end of the laminate structure 33. The first conducting strip 30 and the second conducting strip 32 extend parallel to the length axis *l* (i.e. in the first direction) towards a second end of the laminate structure 33. At the second end, the first conducting strip 30 and the second conducting strip 32 form folds 30c and 32c, respectively. At the folds, the conducting strips extend in a direction of the thickness h of the laminate structure 33 (i.e. in the second direction perpendicular to the plane of the laminate structure). After folding, the first conducting strip 30 and the second conducting strip 32 extend back to the first end of the laminate structure 33, ending finally at second ends 30b and 32b, respectively. The portions of the conducting strips 30 and 32 before folding may extend on different planes (that are parallel to the plane of the laminate structure) than the portions after folding. In this manner, the first conducting strip 30 and the second conducting strip 32 form a first and second inductive loop, respectively. Figures 3a and 3c show that the first ends 30a and 32a and the second ends 30b and 32b have a distance between each other along the width axis w. This increases the loop areas of the first and second inductive loop.

Although not shown in Figures 3a to 3c the first conducting strip 30 and the second conducting strip 32 are connected in parallel. The first end 30a of the first conducting strip 30 may be connected to the first end 32a of the second conducting strip 32, and the second end 30b of the first conducting strip 30 may be connected to the second end 32b of the second conducting strip 32. A galvanic connection between the ends may be produced by crimping, welding or soldering, for example.

In a current conductor structure according to the present disclosure, the second current path (e.g. the second conducting strip 32 in Figures 3a to 3c) has a lower inductance than the first path (e.g. the first conducting strip 30 in Figures 3a to 3c). The inductance of a current path is responsive to the loop area formed by the path. A difference in the loop area may be achieved in many ways. For example, if the second electrically conducting strip wraps around one or more layers of the supporting laminate structure to form the second inductive loop, the first electrically conducting strip may wrap around at least one more layer of the supporting laminate structure than the first electrically conducting strip to form the first inductive loop. The area of the inductive loops may also be controlled by controlling the thicknesses of the layers of the laminate structure. Alternatively, or in addition, the second conducting strip may extend less in the first direction. This also reduces the loop area.

The loop area of the first inductive loop is larger than the loop area of the second inductive loop in Figures 3a to 3c. The second inductive loop is arranged inside the first inductive loop, so that a height $h_1$ of the second loop (in the direction perpendicular to the plane of the laminate structure 33) is higher than a height $h_2$ of the second loop. Further, a length $l_1$ of the first inductive loop (in the direction of the length axis *l*) is longer than a length $l_2$ of the second inductive loop.

According to the present disclosure, the second current path (e.g. the second conducting strip 32 in Figures 3a to 3c) has a higher resistance than the first path (e.g. the first conducting strip 30 in Figures 3a to 3c). The resistance of the paths may be controlled in various ways. For example, the second electrically conducting strip may be made from a different material than the first electrically conducting strip. The first current path may be made of copper foil and the second current path may be made of aluminium foil, for example. Alternatively, or in addition, the second electrically conducting strip may have a different width and/or thickness than the first electrically conducting strip. In the cross-section shown in Figure 3c, a width $w_1$ of the first electrically conducting strip 30 is larger than a width $w_2$ of the second electrically conducting strip 32. Adjusting the width of the electrically conducting strips and/or the position of the ends of the strip may also have an effect to the inductance of the respective inductive loop. For example, making a strip wider may decrease the inductance the loop formed by the strip because the loop area may become smaller. The inductance of an inductive loop formed by a conductive strip according to the present disclosure may be adjusted by controlling the distance between the first end and the second end of the strip. Thus there are many different means to optimize the resistive and inductive component of the loop.

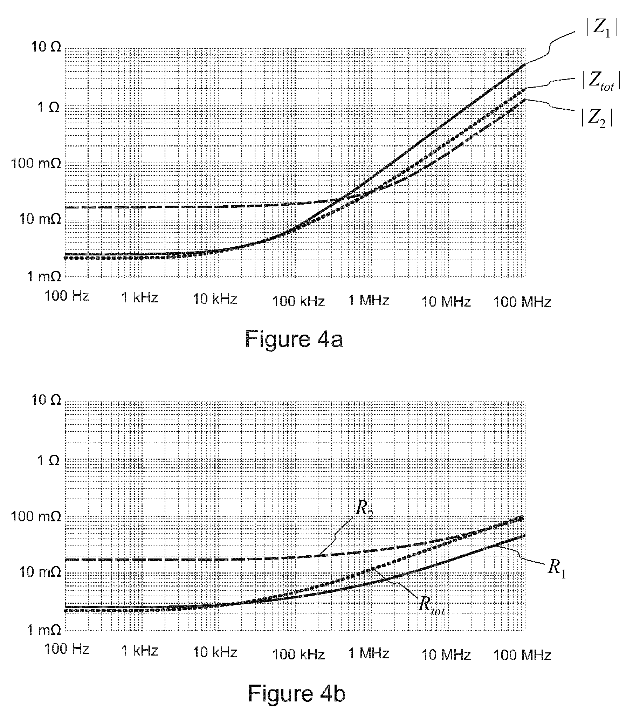

If thin conductor foils are used in the current conductor structure, the skin effect associated with eddy currents may be kept at minimum. Figures 4a and 4b show exemplary, simplified diagrams of impedances of parallel current paths implemented as thin conductor foils in a laminate structure. In Figure 4a, amplitudes of impedances $Z_1$, $Z_2$, and $Z_{tot}$ are shown. The first impedance $Z_1$ of the first current path is represented by a solid line, the second impedance $Z_2$ of the second current path is represented by a dashed line, and the total impedance $Z_{tot}$ of the parallel connection of the two current connectors is represented by a dotted line. In Figure 4b, respective resistance components $R_1$, $R_2$, and $R_{tot}$ of the impedances $Z_1$, $Z_2$, and $Z_{tot}$ are shown as function of frequency with corresponding line patterns. In Figure 4a and 4b, the first current path has a smaller resistance but a higher inductance than the second current path. The skin effect is clearly visible in Figure 4b. It causes the resistances $R_1$ and $R_2$ to increase responsive to the frequency. However, it is also clearly visible that current conductor structure according to the present disclosure structure increases the total resistance component $R_{tot}$ in high frequencies more than the skin-effect alone.

The impedance characteristics of a current conductor structure according to the present disclosure may be adjusted with passive electric components. The first and/or the second current path may comprise a passive component. For example, a passive component may be connected in parallel with the first current conducting strip and/or in parallel with the second current conducting strip. In Figures 3a and 3b, for example, a passive component may have been connected in parallel with the first conducting strip 30 at the fold 30c of the first conducting strip 30. It is also possible to connect a passive component between the first conducting strip and the second conducting strip in order to adjust the impedance characteristics of the current conductor structure.

Also, instead of using continuous conducting strips for forming the first and second current paths according to the present disclosure, the conducting strips may each comprise separate portions connected by an electric component. For example, similar to the embodiments of Figures 3a to 3c, the current conductor structure may comprise one or more layers of insulating material forming a supporting laminate structure. However, the current conductor structure may comprise a first portion and a second portion of a first electrically conducting strip instead of a continuous first electrically conducting strip. The current conductor structure may comprise a first passive electric component electrically coupling the first and second portion together. In Figures 3a and 3b, for example, the current conductor structure may comprise passive electric component instead of fold 30c. The first portion and the second portion may be arranged to extend on different planes that are parallel to the plane of the laminate structure. The first portion, the second portion, and the first passive electric component may be arranged to act as the first current path and form a first inductive loop that extends in a first direction parallel the plane of the laminate structure and in a second direction perpendicular to the plane of the laminate structure. Further, similar to the first electrically conducting strip, the current conductor structure may comprise a first portion and a second portion of a second electrically conducting strip, and a second passive electric component electrically coupling the first and second portion of the second electrically conducting strip together. The first portion and the second portion of the second electrically conducting strip may be arranged to extend on different planes that are parallel to the plane of the laminate structure. The first portion, the second portion, and the passive electric component may be arranged to act as the second current path and form a second inductive loop that extends in the first direction and in the second direction.

The passive electric components may be resistors or capacitors for example. By selecting suitable component values, the impedances of the first and second current path may be adjusted. In addition to using passive component dedicated solely for the current conductor structure, passive components having other functions may also utilized. For example, a capacitor of a DC link in a power electronic converter may also be used for adjusting the impedance of the current conductor structure. In the context of the present disclosure, the term "passive component" or "passive electric component" may be one discrete passive electric component or a plurality of discrete passive components connected in series and/or in parallel.

There are many ways to manufacturing a laminate structure for the current conductor structure according to the present disclosure. Printed circuit board manufacturing process may be used, for example. In one embodiment, the first and second electrically conducting strips may be in the form of self-adhesive tapes each folded around one or more layers of the supporting laminate structure. Manufacturing a current conductor structure with a frequency-dependent resistance may comprise folding an electrically conducting strip around a first layer of insulating material to form an inductive loop. As a result, the strip extends on one surface of the first layer, then folds at an end of the layer, and extends back on the other surface of the first layer. At least one second layer of insulating material may be attached to the first layer to form a laminate structure, and another electrically conducting strip may be folded around the laminate structure. The two electrically conducting strips may then be connected in parallel. The two electrically conducting strips may configured by using above-described principles. One of the two electrically conducting strips may have a higher resistance and a lower inductance than the other electrically conducting strip so that, at frequencies above a set frequency limit, the resistance component of a total impedance of the current conductor structure is larger than the resistance component of the impedance of said other electrically conducting strip.

It will be obvious to a person skilled in the art that, as the technology advances, the inventive concept can be implemented in various ways. The invention and its embodiments are not limited to the examples described above but may vary within the scope of the claims.

**Claims**

1. A current conductor structure with a frequency-dependent resistance, the current conductor structure comprising a first current path and a second current path connected in parallel, wherein the first and second current path are configured such that,
the second current path has a higher resistance and a lower inductance than the first current path so that, above a set frequency limit, the resistance component of a total impedance of the current conductor structure is larger than the resistance component of the impedance of the first current path.

2. A current conductor structure according to claim 1, wherein the current conductor structure comprises
one or more layers of insulating material forming a supporting laminate structure, and
a first electrically conducting strip acting as the first current path, wherein the first electrically conducting strip is arranged to form a first inductive loop that extends in a first direction parallel to a plane of the laminate structure and in a second direction perpendicular to the plane of the laminate structure.

3. A current conductor structure according to claim 2, wherein the current conductor structure further comprises
a second electrically conducting strip acting as the second current path, wherein the second electrically conducting strip is arranged to form a second inductive loop that extends in the first and second direction,
wherein the dimensions of the first and second inductive loop in the first and second direction define loop areas of the first and second inductive loop, and wherein the loop area of the first inductive loop is larger than the loop area of the second inductive loop.

4. A current conductor structure according to claim 3, wherein
the second electrically conducting strip folds around one or more layers of the supporting laminate structure to form the second inductive loop, and
the first electrically conducting strip folds around at least one more layer of the supporting laminate structure than the first electrically conducting strip to form the first inductive loop.

5. A current conductor structure according to claim 3 or 4, wherein the second inductive loop is arranged inside the first inductive loop.

6. A current conductor structure according to any one of claims 3 to 5, wherein the second electrically conducting strip is made from a different material than the first electrically conducting strip.

7. A current conductor structure according to claim 6, wherein the first current path is made of copper foil and the second current path is made of aluminium foil.

8. A current conductor structure according to any one of claims 2 to 7, wherein the second electrically conducting strip has a different width and/or thickness than the first electrically conducting strip.

9. A current conductor structure according to any one of claims 2 to 8, wherein the first and second electrically conducting strips are in the form of self-adhesive tapes each folded around one or more layers of the supporting laminate structure.

10. A current conductor structure according to any one of claims 2 to 9, wherein the first and/or the second current path comprises a passive electric component.

11. A current conductor structure according to claim 1, wherein the current conductor structure comprises
one or more layers of insulating material forming a supporting laminate structure,
a first portion and a second portion of a first electrically conducting strip, and
a first passive electric component electrically coupling the first and second portion of the first electrically conducting strip together,
wherein the first portion of the first electrically conducting strip, the second portion of the first electrically conducting strip, and the first passive electric component are arranged to act as the first current path and form a first inductive loop that extends in the first direction and in the second direction.

12. A current conductor structure according to claim 11, wherein the current conductor structure comprises
a first portion and a second portion of a second electrically conducting strip, and

a second passive electric component electrically coupling the first and second portion of the second electrically conducting strip together,

wherein the first portion of the second electrically conducting strip, the second portion of the second electrically conducting strip, and the passive electric component are arranged to act as the second current path and form a second inductive loop that extends in a first direction in a plane of the laminate structure and in a second direction perpendicular to the plane of the laminate structure.

13. A method for manufacturing a current conductor structure with a frequency-dependent resistance, wherein the method comprises

folding an electrically conducting strip around a first layer of insulating material to form an inductive loop,

attaching at least one second layer of insulating material to the first layer to form a laminate structure,

folding another electrically conducting strip around the laminate structure, and

connecting the two electrically conducting strips in parallel,

wherein two electrically conducting strips are configured such that,

one of the two electrically conducting strips has a higher resistance and a lower inductance than the other electrically conducting strip so that, above a set frequency limit, the resistance component of a total impedance of the current conductor structure is larger than the resistance component of the impedance of said other electrically conducting strip.

10

$Z_{tot}$

$Z_1$

$Z_2$

Figure 1

$|Z_1|$

$|Z_2|$

$|Z_{tot}|$

10 Ω

1 Ω

100 mΩ

10 mΩ

1 mΩ

100 Hz    1 kHz    10 kHz    100 kHz    1 MHz    10 MHz    100 MHz

Figure 2a

10 Ω

1 Ω

100 mΩ

10 mΩ

1 mΩ

$R_2$

$R_{tot}$

$R_1$

100 Hz    1 kHz    10 kHz    100 kHz    1 MHz    10 MHz    100 MHz

Figure 2b

Figure 3a

Figure 3b

Figure 3c

Figure 4a

Figure 4b

Europäisches
Patentamt

European
Patent Office

Office européen
des brevets

# EUROPEAN SEARCH REPORT

**Application Number**

EP 16 18 4177

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/051308 A1 (CHAN NGAR LOONG A [US]) 3 March 2011 (2011-03-03) | 1-3,5-7 | INV. H02M1/44 H01F17/00 |
| A | * paragraph [0029] - paragraph [0036]; figures 3,4 * | 13 | |
| X | US 2005/024176 A1 (WANG SUNG-HSIUNG [TW] ET AL) 3 February 2005 (2005-02-03) * paragraph [0036] - paragraph [0037]; figure 6 * | 1-3,5-7 | |
| A | US 2008/129434 A1 (KHAJEHPOUR JAVAD [CA]) 5 June 2008 (2008-06-05) * paragraph [0022] - paragraph [0024]; figures 2,3a * | 1,13 | |
| A | EP 2 535 931 A2 (ALTERA CORP [US]) 19 December 2012 (2012-12-19) * figures 9-11 * | 1,13 | |

**TECHNICAL FIELDS SEARCHED (IPC)**

H02M
H01F

The present search report has been drawn up for all claims

| Place of search | Date of completion of the search | Examiner |
|---|---|---|
| The Hague | 6 February 2017 | Speiser, Pierre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 16 18 4177

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2017

| Patent document cited in search report | | Publication date | Patent family member(s) | | Publication date |
|---|---|---|---|---|---|
| US 2011051308 | A1 | 03-03-2011 | CN | 102483984 A | 30-05-2012 |
| | | | EP | 2474069 A2 | 11-07-2012 |
| | | | JP | 5882506 B2 | 09-03-2016 |
| | | | JP | 2013503501 A | 31-01-2013 |
| | | | JP | 2015111694 A | 18-06-2015 |
| | | | KR | 20120048034 A | 14-05-2012 |
| | | | US | 2011051308 A1 | 03-03-2011 |
| | | | WO | 2011026133 A2 | 03-03-2011 |
| US 2005024176 | A1 | 03-02-2005 | CN | 1624917 A | 08-06-2005 |
| | | | TW | I230435 B | 01-04-2005 |
| | | | US | 2005024176 A1 | 03-02-2005 |
| US 2008129434 | A1 | 05-06-2008 | NONE | | |
| EP 2535931 | A2 | 19-12-2012 | CN | 102832193 A | 19-12-2012 |
| | | | EP | 2535931 A2 | 19-12-2012 |
| | | | JP | 6018423 B2 | 02-11-2016 |
| | | | JP | 2013004973 A | 07-01-2013 |
| | | | US | 2012319236 A1 | 20-12-2012 |

EPO FORM P0459

For more details about this annex : see Official Journal of the European Patent Office, No. 12/82